# EUROPEAN PATENT APPLICATION

(11) **EP 3 217 418 A2**
(43) Date of publication of application: **13.09.2017**
(21) Application number: 17160201.4
(22) Date of filing: 09.03.2017
(51) Int. Cl.: H01J 1/15, H01J 1/18, H01K 1/14, H01K 1/18, H01J 3/02

(54) **FILAMENT ASSEMBLY FOR GENERATING ELECTRONS, AND RELATED DEVICES, SYSTEMS AND METHODS**

(30) Priority: 11.03.2016 US 201615068160
(71) Applicant: Agilent Technologies, Inc. (A Delaware Corporation), Santa Clara, CA 95051 (US)
(72) Inventor: Geist, Daniel J., Santa Clara, CA California 95051-7201 (US); Calhoun, John, Santa Clara, CA California 95051-7201 (US)
(74) Representative: Dilg, Haeusler, Schindelmann Patentanwaltsgesellschaft mbH

(57) **Abstract**

A filament assembly includes a core and a filament. At least a central portion of the filament is disposed on the core. At least the central portion may be straight or may have a high-resistance configuration such as one in which the filament follows a path that changes direction. A thermionically emissive layer may be disposed on the core so as to encapsulate at least the central portion. The filament assembly may be utilized in any application requiring the production of electrons.

## Description

### TECHNICAL FIELD

The present invention relates to filament assemblies utilized to generate electrons, and devices utilizing filament assemblies such as electron sources, ion sources, and associated systems.

### BACKGROUND

Many technologies entail the use of an electron source (or electron emitter), i.e., a device that generates a stream of electrons in a vacuum. The electron source may utilize a hot cathode (or thermionic cathode) to generate electrons. The hot cathode is often provided in the form of a heated filament composed of a refractory material (e.g., tungsten) or other high-melting point material (e.g., iridium), and which may be coated with a low-work function material (e.g., yttrium oxide). The ends of the filament are coupled to a voltage source that applies a voltage across the filament. The resulting electrical current running through the filament resistively heats it to a point (e.g., 1800 °C) sufficient to cause thermionic emission of energetic electrons (sometimes referred to as "thermions" in this context) from the surface of the flament or from the low-work function coating if provided. Stated differently, electrons boil off of the surface of the filament or coating. The electron source may include an anode and one or more additional electrodes (electron optics) configured to focus and accelerate the as-generated electrons as a beam, and to steer the beam as required in a given application, through the generation of one or more electrostatic fields of appropriate spatial and polar orientation.

The heated filament is often implemented as a wire wound into the form of a coil. The two ends of the filament are attached (e.g., by welding) to two respective posts (e.g., stainless steel), which in turn are electrically coupled to the voltage source to complete the electrical circuit. The coil is thereby suspended between the two posts, but otherwise is freestanding in space. The intense heating of the filament causes it to move in unpredictable directions due to thermal expansion and thermal stress relieving in the coiled wire. Because the filament sags and warps, the focus and the direction of the electron stream becomes suboptimal. Consequently, the electrical current to the filament needs to be increased to keep the level of electrons provided for downstream processes constant. However, increasing the electrical current increases the heat in the filament, which further degrades the useful life of the filament. Another consequence of heating is that the metal filament material sublimates at a very slow and uneven rate, which causes notches to form along the surface of the coil. Hot spots begin to develop at the notches, further deepening the notches. The notching coupled with the heating and movement of the causes the filament to eventually fail, such as by breaking at a notch.

Therefore, there is an ongoing need for improved filament assemblies that address the above-noted problems.

### SUMMARY

To address the foregoing problems, in whole or in part, and/or other problems that may have been observed by persons skilled in the art, the present disclosure provides methods, processes, systems, apparatus, instruments, and/or devices, as described by way of example in implementations set forth below.

According to one embodiment, a filament assembly includes: a core composed of an electrically insulating, high-melting point material and having a core length along a core axis; and a filament composed of an electrically conductive, high-melting point material and comprising a first end, a second end, and an elongated body between the first end and the second end, wherein at least a central portion of the body is disposed on the core.

In some embodiments, at least the central portion of the body extends along at least a portion of the core length in a high-resistance configuration.

According to another embodiment, a thermionically emissive layer is disposed on the core and encapsulating at least the central portion, the thermionically emissive layer having a work function lower than a work function of the filament.

According to another embodiment, a method for fabricating a filament assembly includes: providing a core composed of an electrically insulating, high-melting point material and having a core length along a core axis; providing a filament composed of an electrically conductive, high-melting point material and comprising a first end, a second end, and an elongated body between the first end and the second end; and attaching the filament to the core such that at least a central portion of the body is disposed on the core.

According to another embodiment, the method includes applying a thermionically emissive layer to the core such that the thermionically emissive layer encapsulates at least the central portion, the thermionically emissive layer having a work function lower than a work function of the filament.

According to another embodiment, an electron source includes: a filament assembly according to any of the embodiments disclosed herein; and a vacuum chamber in which the filament assembly is disposed.

According to another embodiment, an ion source includes: a filament assembly according to any of the embodiments disclosed herein; an ionization chamber; a sample inlet configured for directing a sample into contact with electrons in the ionization chamber emitted from the filament assembly; and an ion outlet configured for directing ions out from the ionization chamber.

According to another embodiment, an analytical instrument includes: an ion source including a filament assembly according to any of the embodiments disclosed herein; and a mass spectrometer communicating with the ion outlet.

According to another embodiment, a method for ionizing a sample includes: applying a voltage to a first end and a second end of a filament of a filament assembly according to any of the embodiments disclosed herein to produce an electron beam; and contacting the sample with the electron beam.

Other devices, apparatus, systems, methods, features and advantages of the invention will be or will become apparent to one with skill in the art upon examination of the following figures and detailed description. It is intended that all such additional systems, methods, features and advantages be included within this description, be within the scope of the invention, and be protected by the accompanying claims.

### BRIEF DESCRIPTION OF THE DRAWINGS

The invention can be better understood by referring to the following figures. The components in the figures are not necessarily to scale, emphasis instead being placed upon illustrating the principles of the invention. In the figures, like reference numerals designate corresponding parts throughout the different views.
Figure 1 is a schematic perspective view of an example of a filament assembly according to an embodiment.
Figure 2A is a schematic perspective view of an example of a core and a sheet or layer of filament material according to an embodiment.
Figure 2B is a schematic perspective view of the core and sheet or layer of filament material illustrated in Figure 2A after a photoresist has been added according to an embodiment.
Figure 2C is a schematic perspective view of a filament assembly after etching the filament material illustrated in Figure 2B and removing the photoresist according to an embodiment.
Figure 2D is a schematic perspective view of the filament assembly illustrated in Figure 2C after the filament assembly has been operatively coupled to filament posts.
Figure 2E is a schematic perspective view of a longitudinal section of the filament assembly illustrated in Figure 2C.
Figure 3A is a schematic perspective view of an example of a core and a sheet or layer of filament material according to another embodiment.
Figure 3B is a schematic perspective view of an example of a filament assembly fabricated from the core and filament material illustrated in Figure 3A, after the filament assembly has been operatively coupled to filament posts according to an embodiment.
Figure 4 is a schematic perspective view of an example of a filament assembly according to another embodiment.
Figure 5 is a schematic view of an example of an electron source (or electron emitter) according to an embodiment.

### DETAILED DESCRIPTION

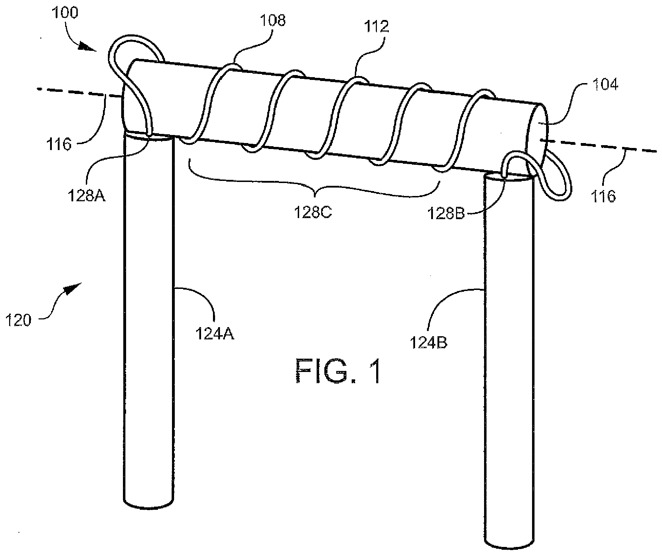

Figure 1 is a schematic view of an example of a filament assembly 100 according to an embodiment. Generally, the filament assembly 100 may include a core 104 and a filament 108. In some embodiments, the filament assembly 100 may also include a thermionically emissive layer 112. In some embodiments, the filament assembly 100 may also include filament posts, as described below.

Generally, the core 104 may be composed of a material capable of reliably providing a solid support surface for the filament 108, while withstanding thermal cycling involving high temperatures without failing (e.g., cracking, decomposing, etc.), over the service life of the filament assembly 100. In the context of the present disclosure, high temperatures are generally temperatures high enough to produce electrons by boiling (i.e., thermionic emission) without melting the filament material or a thermionically emissive material coating the filament material, one non-limiting example being approximately 1800 °C. For convenience, a core material as described herein is referred to as a high-melting point material. Thus the core material may be selected from, for example, a wide range of refractory materials, examples of include, but are not limited to, various ceramics, metal (or metalloid) oxides, carbides, nitrides, and clays. Moreover, the core material is typically an electrically insulating material, and thus may be a non-metallic refractory material as just noted. In the present context, the term "electrically insulating material" encompasses dielectric materials. The core 104 generally has a core length along a core axis 116. The core length may be the dominant dimension of the core 104, i.e., the core 104 may be elongated along the core axis 116. The core 104 may be solid or hollow. In some embodiment, the "solid" core material may be a highly compressed packing of powders, particulates, or mineral aggregates, such as may be formed by ball milling or other techniques for engineering solid objects from powders or the like. The core 104 may have a monolithic or composite structure. As an example of the latter, the core 104 may include an outer shell (e.g., a tube) enclosing a filler or core material. In the illustrated embodiment, the core 104 is cylindrical, while in other embodiments may generally be any other shape suitable for supporting the filament 108 in a stationary form effective for generating a stable stream of electrons.

The core 104 may be attached or mounted to any suitable support structure 120 by any suitable means (e.g., adhesive, glue, resin, welding, or fasteners, or corresponding features on the core 104 and support structure 120 that contact, engage, or interlock with each other, etc.) capable of reliably supporting the core 104 while withstanding thermal cycling involving high temperatures as described above. In various embodiments, the support structure 120 may be considered as being a part of the filament assembly 100 and/or as being a part of an instrument or system in which the filament assembly 100 is installed. In the illustrated embodiment, the support structure 120 is or includes a pair of filament posts 124A and 124B. The axial ends of the core 104 are respectively attached or mounted to the filament posts 124A and 124B. The filament posts 124A and 124B may be the same or similar type of posts conventionally utilized to support a filament in an electron (impact) ionization (EI) source, as appreciated by persons skilled in the art. Thus in practice the filament posts 124A and 124B may be coupled to the voltage source that provides power to the filament 108 and completes the electrical circuit.

The filament 108 may be composed of any electrically conductive, high-melting point material, i.e., a material capable of withstanding temperatures high enough to produce electrons by boiling (i.e., thermionic emission) without melting the filament material or a thermionically emissive material coating the filament material. Thus, for example, the filament 108 may be composed of a refractory metal or other high-melting point metal, or alloy of any refractory metal or other high-melting point metal, or high-melting point semiconductor, suitable for use in or as a thermionic cathode. Examples include, but are not limited to, iridium, tungsten, rhenium, and alloys thereof (e.g., tungsten-rhenium). The filament 108 includes a first end 128A, a second end 128B, and an elongated body between the first end 128A and the second end 128B. The body may be shaped as a wire (i.e., with a round cross-section) as illustrated, or as a ribbon or strip (i.e., a flat, planar geometry with a rectilinear cross-section). Typically, but not exclusively, the cross-section of the filament 108 (i.e., the body) has dimensions on the order of millimeters (mm).

Generally, the first end 128A and the second end 128B may be placed in electrical communication with the filament posts 124A and 124B by any suitable means. Depending on the embodiment, the first end 128A and the second end 128B may be placed in electrical communication with the filament posts 124A and 124B by either a direct connection or indirect connection (e.g., via intermediate contact wires) between the first and second ends 128A and 128B and the filament posts 124A and 124B. In the present embodiment in which the filament 108 is wire-shaped, the first end 128A and the second end 128B may be placed in electrical communication with the respective filament posts 124A and 124B by connecting the first end 128A and the second end 128B directly to the filament posts 124A and 124B such as by, for example, welding. If space permits, the first end 128A and second end 128B may be electrically connected to the ends (i.e., the tops, from the perspective of Figure 1) of the filament posts 124A and 124B near the axial ends of the core 104. Otherwise, the first end 128A and second end 128B may be electrically connected to the sides of the filament posts 124A and 124B at points near the ends at which the core 104 is mounted or attached.

At least a central portion 128C of the body is disposed on the core 104. It may be desirable for the entire length of the filament 108 to be disposed on and thus supported by the core 104, except for the first end 128A and second end 128B which may need at least some freedom of movement to facilitate electrically connecting them to the filament posts 124A and 124B. Hence, the central portion 128C of the body that is disposed on the core 104 may extend for the entire or substantially entire length of the core 104, and the lengths of the end portions of the filament 108 (portions that terminate at the respective first end 128A and second end 128B) that are suspended between the core 104 and the filament posts 124A and 124B may be minimized.

In some embodiments, the filament 108 or at least the central portion 128C is straight or substantially straight, i.e., extends along at least a portion of the core length in a straight or substantially straight path. In other embodiments and as illustrated, the filament 108 or at least the central portion 128C extends along at least a portion of the core length in a high-electrical resistance (or high-resistance) configuration. In the context of the present disclosure, a "high-electrical resistance configuration" or "high-resistance configuration" refers to a configuration of a filament that provides an electrical path of significant resistance, for example an electrical path of increased resistance as compared to a straight filament. As one non-limiting example, a high-resistance configuration may be realized by imposing multiple changes in the direction along which the filament material runs, again as compared to a straight filament. In such case, the high-resistance configuration may be described as being a multi-directional (or multi-turn, or multi-bend) configuration in which the path of the filament material changes direction one or more times. In the present embodiment, the high-resistance configuration is realized by at least the central portion 128C being wound about the core 104 (and thus the core axis 116) in a helical path. That is, at least the central portion 128C is formed as a helical coil. In other embodiments, an example of which is described below, the high-resistance configuration may be realized as a serpentine (or labyrinthine) path.

To ensure that at least the central portion 128C of the filament 108 remains fully supported on the core 104 during operation and does not move in response to being heated, at least the central portion 128C may be attached (e.g., adhered, bonded, etc.) to the core 104 by a suitable bonding agent (or adhesive, etc.). In some embodiments, the thermionically emissive layer 112 may serve as an effective bonding agent, without the need for use of a separate bonding agent.

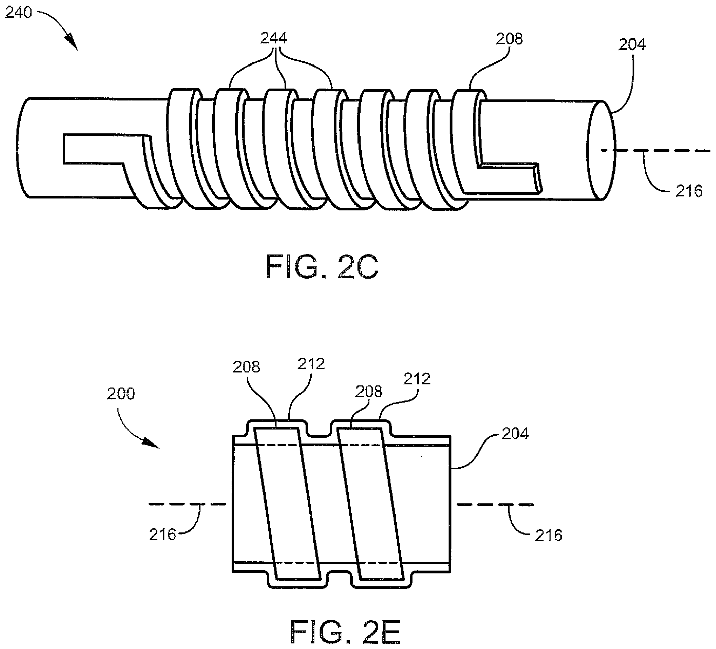

The thermionically emissive layer 112 is disposed on the core 104 so as to conformally cover (i.e., encapsulate) at least the central portion 128C of the filament 108 (as shown in greater detail in Figure 2E, described below). Depending on its composition, the thermionically emissive layer 112 may be applied as a wet coating or slurry that thereafter sets, hardens, or solidifies via drying, evaporation, or other mechanism for removing the liquid phase. Any method for applying the thermionically emissive layer 112 suitable for its composition may be implemented. Examples include, but are not limited to, dip coating, spray coating, drop coating, spin coating, painting, doctor blading, printing, etc. To enhance thermionic emission, the material of the thermionically emissive layer 112 may have a work function that is lower than the work function of the filament 108. Examples of suitable materials for forming the thermionically emissive layer 112 include, but are not limited to, a thermionically emissive oxide or a mixture of two or more different thermionically emissive oxides, such as yttrium oxide or a mixture of yttrium oxide and one or more other thermionically emissive oxides, and a thermionically emissive allotrope of carbon such as carbon nanotubes, graphene, and derivatives of carbon nanotubes, graphene, or other carbon allotropes, or composite structures containing two or more different carbon allotropes.

An example of a method for fabricating the filament assembly 100 according to an embodiment will now be described. Generally, the core 104 and the filament 108 may be provided such that at least the central portion 128C of the body of the filament 108 is disposed on the core 104. As described above, in some embodiments the filament 108 or at least the central portion 128C may extend along at least a portion of the core length in a high-resistance configuration. Specifically in the present embodiment, the filament 108 is provided in the form of a wire, and the high-resistance configuration is formed by winding the central portion 128C about the core 104 in a helical path. With the filament assembly 100 so assembled, the filament assembly 100 is then mounted on the filament posts 124A and 124B by mounting or attaching the axial ends of the core 104 on or to the respective filament posts 124A and 124B. The first end 128A and the second end 128B of the filament 108 are then electrically connected to the respective filament posts 124A and 124B such as by, for example, welding. The filament assembly 100 and the filament posts 124A and 124B may thereafter be installed as a unit in an ion source or other instrument. Alternatively, the filament posts 124A and 124B may be pre-installed in an ion source or other instrument at the time the filament assembly 100 is mounted and electrically connected to the filament posts 124A and 124B. After mounting the filament assembly 100 to the filament posts 124A and 124B, the thermionically emissive layer 112 may then be applied to the core 104 such that the thermionically emissive layer 112 encapsulates (e.g., is conformally disposed on) at least the central portion 128C. In one specific yet non-limiting embodiment, the thermionically emissive layer 112 is applied by dipping the core 104 (with the filament 108 disposed thereon) in a slurry of (or containing) the thermionically emissive material. The thermionically emissive material may thereafter be dried, cured, etc., as needed. Alternatively, the thermionically emissive layer 112 may be applied before mounting the filament assembly 100 to the filament posts 124A and 124B.

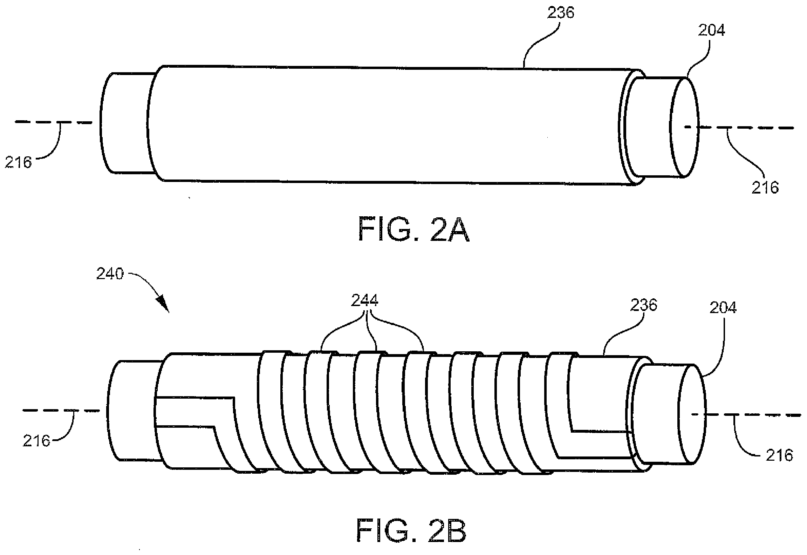

Figures 2A-2E are schematic perspective views illustrating an example of a method for fabricating a filament assembly 200 according to an embodiment.

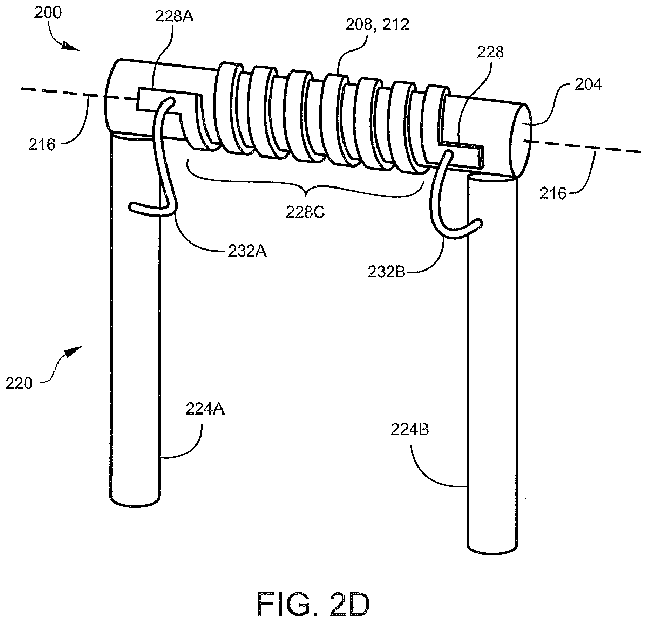

Reference is first made to Figure 2D, which illustrates an example of the fabricated filament assembly 200 after it has been mounted and electrically connected to filament posts 224A and 224B, and Figure 2E, which illustrates an example of a longitudinal section of the fabricated filament assembly 200. The filament assembly 200 may include a core 204, a filament 208, and a thermionically emissive layer 212. The material compositions of the core 204, filament 208, and thermionically emissive layer 212 maybe as described above in regard to the filament assembly 100 illustrated in Figure 1.

The core 204 has a core length along a core axis 216, and may be elongated along the core axis 216. The core 204 may be solid or hollow, and may have a monolithic or composite structure. In the illustrated embodiment, the core 204 is cylindrical, while in other embodiments may generally be any other shape suitable for supporting the filament 208 and generating a stable stream of electrons in operation.

The core 204 may be attached or mounted to any suitable support structure 220 by any suitable means as described above. As noted above, depending on the embodiment the support structure 220 may be considered as being a part of the filament assembly 200 and/or as being a part of an instrument or system in which the filament assembly 200 is installed. In the illustrated embodiment, the support structure 220 is or includes a pair of filament posts 224A and 224B. The axial ends of the core 204 are respectively attached or mounted to the filament posts 224A and 224B.

The filament 208 includes a first end 228A, a second end 228B, and an elongated body between the first end 228A and the second end 228B. In the present embodiment, the body is shaped as a ribbon or strip. Typically, but not exclusively, the cross-section of the filament 208 (i.e., the body) has dimensions on the order of millimeters (mm).

Generally, the first end 228A and the second end 228B may be placed in electrical communication with the filament posts 224A and 224B by any suitable means. In the present embodiment in which the filament 208 has a flat, planar geometry, the first end 228A and the second end 228B may be placed in electrical communication with the respective filament posts 224A and 224B via respective contact wires 232A and 232B. That is, the contact wires 232A and 232B provide respective electrical interconnections between the first end 228A and second end 228B and the filament posts 224A and 224B. Specifically, the opposing ends of the contact wire 232A may be respectively connected to the first end 228A and the filament post 224A (e.g., by welding), and the opposing ends of the contact wire 232B may be respectively connected to the second end 228B and the filament post 224B (e.g., by welding). If space permits, the first end 228A and second end 228B may be electrically connected to the ends of the filament posts 224A and 224B near the axial ends of the core 204. Otherwise, as illustrated the first end 228A and second end 228B may be electrically connected to the sides of the filament posts 224A and 224B at points near the ends at which the core 204 is mounted or attached.

At least a central portion 228C of the body is disposed on the core 204. As described above, in some embodiments at least the central portion 228C may extend along at least a portion of the core length in a high-resistance configuration. In the present embodiment, the flat, planar geometry of the filament 208 and the use of contact wires 232A and 232B as interconnections with the filament posts 224A and 224B allows the entire length of the filament 208 to be disposed on and thus supported by the core 204. In the present embodiment, the high-resistance configuration is realized by at least the central portion 228C being wound about the core 204 (and thus the core axis 216) in a helical path. As described herein, in other embodiments the high-resistance configuration may be realized as a serpentine (or labyrinthine) path.

As in other embodiments and as best shown in Figure 2D, the thermionically emissive layer 212 is disposed on the core 204 so as to encapsulate at least the central portion 228C of the filament 208.

An example of method for fabricating the filament assembly 200 according to an embodiment will now be described with reference to Figures 2A-2E. Generally, the core 204 and the filament 208 may be provided such that at least the central portion 228C of the body of the filament 208 is disposed on the core 204, and may extend along at least a portion of the core length in a high-resistance configuration. In the present embodiment this may be achieved by a technique of laser lithography or ultraviolet (UV) lithography (photolithography) that is compatible with three-dimensional objects. One non-limiting example of a lithographic process that may be employed is described below. In other embodiments other fabrication techniques, including non-lithographic techniques, may be employed.

Referring to Figure 2A, the core 204 may be provided in the form of a solid or hollow cylinder. The filament 208 may be provided by first disposing or forming a sheet or layer 236 of filament material on the core 204, either around the entire outer longitudinal surface of the core 204 to form a tube or cylinder of filament material, or around at least a section of the outer longitudinal surface of the core 204 to form a tube or cylinder of filament material. The sheet or layer 236 of filament material may be disposed or formed on the core 204 by any process suitable for the composition of the filament material. As one example, the filament material may be formed by a vacuum deposition technique such as a suitable chemical vapor deposition (CVD) or a physical vapor deposition (PVD) technique. As another one example, the filament material may be initially provided as a pre-formed sheet, which is then wrapped around the core 204. The pre-formed sheet may be secured to the core 204 using a suitably strong and heat-resistant bonding medium capable of withstanding the thermal cycling encountered in the use of the filament assembly 200 without causing delamination of the filament material from the core 204.

Referring to Figure 2B, the sheet or layer 236 of filament material is coated with a layer 240 of photoresist such as an epoxy-based photoresist (e.g., SU-8). In the illustrated example, a pattern 244 matching the desired high-resistance configuration may then be defined on the photoresist by directing electromagnetic energy (e.g., visible light, ultraviolet (UV) light, etc.) through a correspondingly patterned photomask (not shown) at an appropriate wavelength (nm) and dose (mJ/cm²). Other embodiments may utilize another type of exposure energy such as an electron beam, x-ray energy, or laser light. In the illustrated embodiment the pattern 244 is helical, while in other embodiments may be serpentine or labyrinthine as noted above. For a three-dimensional object such as the layer 236 of filament material, the photomask may first be aligned with and applied conformingly onto the layer 236 of filament material prior to irradiating the assembly with the UV light. Alternatively, a more conventional photomask and reticle may be utilized, and either rotated in angular increments about the core axis 216 or held stationary while the assembly of the core 204, filament material layer 236, and photoresist layer 240 is rotated in angular increments about the core axis 216. It is contemplated that the level of feature resolution and accuracy required for microelectronic fabrication is not required for the process of filament fabrication disclosed herein.

A negative photoresist may be utilized, which is inherently soluble to an appropriately selected photoresist developer solution (or "developer"). The regions of the negative photoresist that are exposed to the UV light through the windows (openings) of the photomask become insoluble to the developer upon exposure to the UV light (due to curing or cross-linking), while the unexposed regions remain soluble to the developer. In this case, the pattern of the photomask positively (or directly) matches the pattern 244 of the desired high-resistance configuration. Alternatively, a positive photoresist may be utilized, which is inherently insoluble to the developer. The regions of the positive photoresist that are exposed to the UV light through the windows of the photomask become soluble to the developer upon exposure to the UV light (due to denaturing or other mechanism of degradation), while the unexposed regions remain insoluble to the developer. In this case, the pattern of the photomask is complementary to, or inversely or negatively matches, the pattern 244 of the desired high-resistance configuration.

In either case, exposing the assembly to the UV light creates a pattern of insoluble photoresist in the photoresist layer. After exposure, the photomask is then removed, and the developer is applied to dissolve the soluble regions of the photoresist. The developer and dissolved photoresist materials are then rinsed away. This results in the pattern 244 of filament material being protected by the remaining photoresist (that is insoluble to the developer) while the remaining portions of the layer 236 of filament material are now exposed.

Referring to Figure 2C, a suitable wet etchant (e.g., chemical) or dry etchant (e.g., oxygen plasma, ion beam, etc.) is then applied to the assembly to remove the exposed portions of the layer 236 of filament material, thereby leaving only the pattern 244 of filament material on the core 204. The remaining photoresist disposed on the pattern 244 of filament material is then removed by a suitable etchant or other means, thereby completing the fabrication of the filament 208 with the high-resistance configuration.

Persons skilled in the art will appreciate that the above lithographic-based process may include other steps not described in detail herein, such as surface preparation or cleaning, rinsing, baking, etc.

Referring to Figure 2D, the filament assembly 200 may then be assembled to the filament posts 224A and 224B by mounting or attaching the axial ends of the core 204 on or to the respective filament posts 224A and 224B. The first end 228A and the second end 228B of the filament 208 may then be electrically coupled to the respective filament posts 224A and 224B by interconnecting the contact wires 232A and 232B, respectively, between the first and second ends 228A and 228B and the filament posts 224A and 224B as described above. The filament assembly 200 and the filament posts 224A and 224B may thereafter be installed as a unit in an ion source. Alternatively, the filament posts 224A and 224B may be pre-installed in an ion source at the time the filament assembly 200 is mounted and electrically connected to the filament posts 224A and 224B.

Figure 2E is a side view of a longitudinal section of the filament assembly 200 (a length of the filament assembly 200 along the core axis 216) occupied by two turns of the filament 208. As shown, after or before mounting the filament assembly 200 to the filament posts 224A and 224B, the thermionically emissive layer 212 may be applied to the core 204 as described above, such that the thermionically emissive layer 212 encapsulates (e.g., is conformally disposed on) at least the central portion 228C (Figure 2D) of the filament 208, thereby completing the fabrication of the filament assembly 200.

In another embodiment of a method for fabricating the filament assembly 200, the core 204 may be provided in the form of a solid or hollow cylinder, and the filament 208 may be provided by first disposing or forming a sheet or layer 236 of filament material on the core 204, as described above. A mask having a pattern of openings that negatively matches the pattern 244 of the high-resistance configuration (if desired) is aligned with and applied conformingly onto the layer 236 of filament material. Hence, regions of the filament material corresponding to the pattern 244 are protected underneath the mask, while the remaining regions of the filament material are exposed through the openings of the mask. A suitable wet or dry etchant, to which the mask itself is unreactive, is then applied to the assembly, whereby the unprotected regions of the filament material are etched away. This results in the formation of the filament 208 with the high-resistance configuration. The thermionically emissive layer 212 may then applied to the core 204 as described above, thereby completing the fabrication of the filament assembly 200.

In another embodiment of a method for fabricating the filament assembly 200, the filament 208 with the high-resistance configuration as desired is formed by a material-additive process instead of the above-described material-subtractive processes. The core 204 may be provided in the form of a solid or hollow cylinder as described above. A mask having a pattern of openings that positively (or directly) matches the pattern 244 of the desired high-resistance configuration is aligned with and applied conformingly onto the core 204. The filament material is then deposited through the openings of the mask, such as by, for example, CVD or PVD. This results in the formation of the filament 208 with the high-resistance configuration. The thermionically emissive layer 212 may then applied to the core 204 as described above, thereby completing the fabrication of the filament assembly 200.

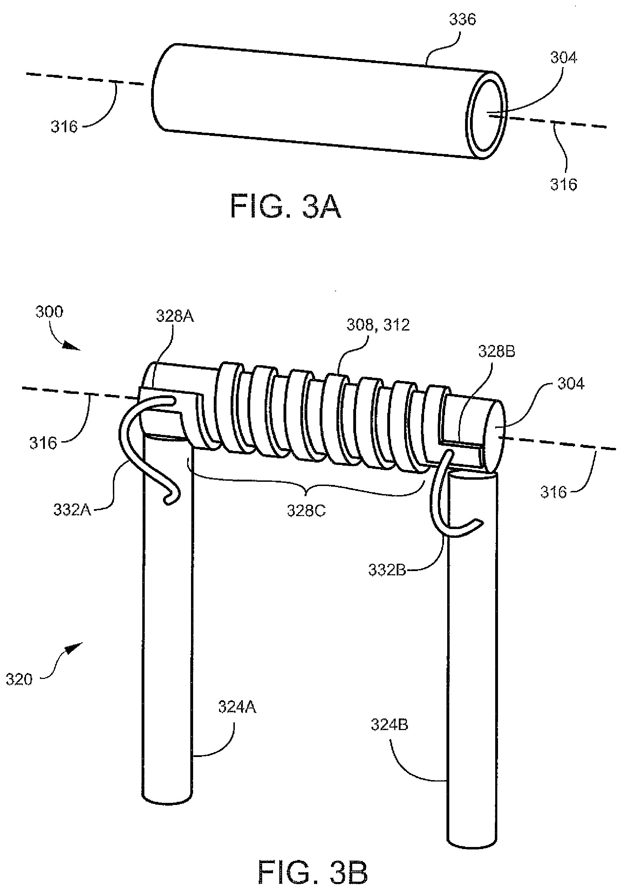

Figures 3A and 3B are schematic perspective views illustrating an example of a method for fabricating a filament assembly 300 according to another embodiment.

Reference is first made to Figure 3B, which illustrates an example of the fabricated filament assembly 300 after it has been mounted and electrically connected to filament posts 324A and 324B. The filament assembly 300 may include a core 304, a filament 308, and a thermionically emissive layer 312. The material compositions of the core 304, filament 308, and thermionically emissive layer 312 may be as described above in regard to the filament assembly 100 illustrated in Figure 1.

The core 304 has a core length along a core axis 316, and may be elongated along the core axis 316. The core 304 may be solid or hollow, and may have a monolithic or composite structure. In the illustrated embodiment, the core 304 is cylindrical, while in other embodiments may generally be any other shape suitable for supporting the filament 308 and generating a stable stream of electrons in operation. The core 304 may be attached or mounted to any suitable support structure 320 by any suitable means as described above. As noted above, depending on the embodiment the support structure 320 may be considered as being a part of the filament assembly 300 and/or as being a part of an instrument or system in which the filament assembly 300 is installed. In the illustrated embodiment, the support structure 320 is or includes a pair of filament posts 324A and 324B. The axial ends of the core 304 are respectively attached or mounted to the filament posts 324A and 324B.

The filament 308 includes a first end 328A, a second end 328B, and an elongated body between the first end 328A and the second end 328B. In the present embodiment, the body is shaped as a ribbon or strip. The cross-section of the filament 308 (i.e., the body) may have dimensions (e.g., width and height) similar to those given above for the filament 208 illustrated in Figures 2C-2E. Generally, the first end 328A and the second end 328B may be placed in electrical communication with the filament posts 324A and 324B by any suitable means. In the present embodiment in which the filament 308 has a flat, planar geometry, the first end 328A and the second end 328B may be placed in electrical communication with the respective filament posts 324A and 324B via respective contact wires 332A and 332B, as described above in conjunction with the filament assembly 200 illustrate in Figure 2E. As described above, at least a central portion 328C of the body is disposed on the core 304, and may extend along at least a portion of the core length in a high-resistance configuration which may, for example, present a helical path or a serpentine (or labyrinthine) path.

As in other embodiments, the thermionically emissive layer 312 is disposed on the core 304 so as to encapsulate at least the central portion 328C of the filament 308.

Figure 3A illustrates an example of initial steps of a method for fabricating the filament assembly 300. The filament assembly 300 may be fabricated in a manner similar to that described above for the filament assembly 200, except that the filament material is initially provided in the form of a hollow cylinder 336 and a core precursor material is initially provided in a slurry, for example a slurry of ceramic material (e.g., particles) and water, and optionally one or more functional additives such as a binding agent. The slurry is poured into the volume enclosed by the cylinder of filament material until the slurry fills all or part of the volume, and thereafter is allowed to set so as to form a solid core 304 capable of supporting the filament material. Depending on the embodiment and the composition of the slurry, various process steps may be carried out to form the solid core 304. For example, multiple alternating steps of compressing (compacting, packing) the slurry into the cylinder 336 (such as by operating a piston structure to allow water to escape the volume) and pouring additional slurry into the cylinder 336 may be needed. As another example, appropriate steps may be carried out to complete the processes of removing the water and setting or solidifying the core precursor material, such as air-drying, vacuum-drying, firing, baking, sintering, curing, etc.

Once the assembly shown in Figure 3A has been formed, the filament 308 with the high-resistance configuration may then be formed according to any of the methods described herein. The resulting filament assembly 300 may then be assembled to the filament posts 324A and 324B by mounting or attaching the axial ends of the core 304 on or to the respective filament posts 324A and 324B, and placing the first end 328A and the second end 328B of the filament 308 in electrical communication with the respective filament posts 324A and 324B via the contact wires 332A and 332B, as shown in Figure 3B and as described above. As shown, after or before mounting the filament assembly 300 to the filament posts 324A and 324B, a conformal thermionically emissive layer may be added according to any of the methods described herein.

In another embodiment, the filament material may be initially provided in the form of a hollow cylinder 336 as just described, and the core 304 maybe initially provided in the form of a solid body, for example a rod-shaped body that may be cylindrical similar to other embodiments disclosed herein. The solid core 304 may be inserted into the hollow cylinder 336 (which may entail, for example, press-fitting the solid core 304 into the hollow cylinder 336), after which further processing and/or assembly steps may be carried out as described herein.

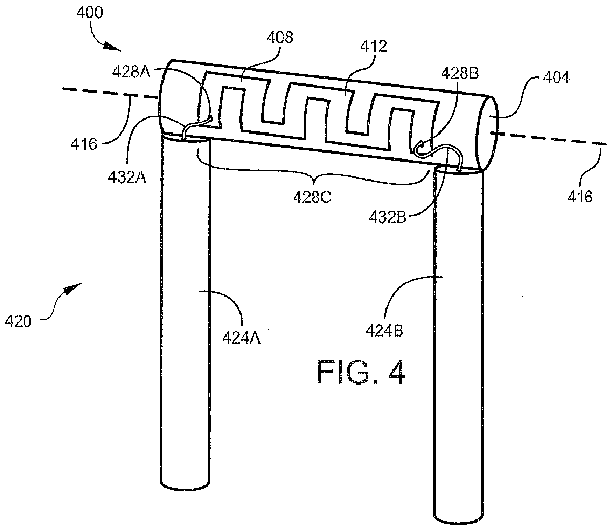

Figure 4 is a schematic perspective view of an example of a filament assembly 400 according to another embodiment. The filament assembly 400 may include a core 404, a filament 408, and a thermionically emissive layer 412. The material compositions of the core 404, filament 408, and thermionically emissive layer 412 may be as described above in regard to the filament assembly 100 illustrated in Figure 1.

Generally, the configuration of the filament assembly 400 may be similar to that of the filament assembly 200 described above and illustrated in Figures 2A-2D or the filament assembly 300 described above and illustrated in Figures 3A and 3B. Thus, the core 404 has a core length (elongated) along a core axis 416. The core 404 may be solid or hollow, may have a monolithic or composite structure, may be cylindrical or have another suitable shape, and may be attached or mounted to any suitable support structure 420 such as a pair of filament posts 424A and 424B. The axial ends of the core 404 may be respectively attached or mounted to the filament posts 424A and 424B.

The filament 408 includes a first end 428A, a second end 428B, and an elongated body between the first end 428A and the second end 428B. The body may be shaped as a ribbon or strip, the dimensions of which may be on the order of millimeters (mm) and may be the same as or similar to those given above by non-limiting example for the filament 208 illustrated in Figures 2C-2E. The first end 428A and the second end 428B may be placed in electrical communication with the filament posts 424A and 424B by any suitable means, such as by providing electrical interconnections via respective contact wires 432A and 432B. At least a central portion 428C of the body is disposed on the core 404, and may extend along at least a portion of the core length in a high-resistance configuration. In the present embodiment, the flat, planar geometry of the filament 408 and the use of contact wires 432A and 432B as interconnections with the filament posts 424A and 424B allows the entire length of the filament 408 to be disposed on and thus supported by the core 404. In the present embodiment and as illustrated, the high-resistance configuration is realized by at least the central portion 428C traversing at least a section of the outer surface of the core 404 along a serpentine or labyrinthine path.

As in other embodiments, the thermionically emissive layer 412 is disposed on the core 404 so as to encapsulate at least the central portion 428C of the filament 408.

The filament assembly 400 may be fabricated according to any of the methods described elsewhere herein. In particular the filament 408, with a high-resistance configuration if desired, may be formed according to any of the material-additive or material-subtractive processes described herein. In another embodiment, the filament 408 may be pre-formed with the high-resistance configuration, and then the filament 408 may be mounted or attached to the core 404 by a suitable bonding or lamination technique.

The present disclosure additionally encompasses other embodiments in which the filament assembly includes a combination of components or features from any of the embodiments described above, including the embodiments illustrated in Figures 1-4.

From the foregoing description, it is evident that filament assemblies as disclosed herein may offer one or more advantages in comparison to known filament assemblies. First, the filament may be supported along its entire length or along most of its length, thereby eliminating or at least minimizing movement and deformation of the filament caused by heating. Second, the filament may be constructed such that stresses are eliminated or at least minimized, which also contributes to eliminating or at least minimizing movement and deformation of the filament caused by heating. Third, the configuration of the filament assembly may enable the thermionically emissive layer to be formed in a more uniform manner, thereby enabling the sample density of electrons to be boiled off the thermionically emissive layer at a lower filament temperature. Fourth, the dimensional accuracy of the features of the filament assembly may be improved, thereby improving the focus of the electrons and resulting in a lower operating current. Any or all of the above advantages may contribute to improving increasing filament life and the stability of the electron stream may be increased. The stability may remain at a high level for longer periods of use and over the longer lifetime of the filament.

A filament assembly as disclosed herein may be utilized as an electron source (or electron emitter) in conjunction with any apparatus or system that requires the generation of free electrons. Examples include, but are not limited to, electron guns such as may be utilized in cathode ray tubes (CRTs), devices for studying particle physics, etc.; systems for fabrication or microfabrication that require an electron beam (e-beam) for interaction with surfaces or molecules; analytical/measurement instruments and detectors utilizing electron beams for illumination, such as electron microscopes; analytical/measurement instruments and detectors utilizing electron beams for ionization of molecules or fragmentation of ions, such as mass spectrometers; devices requiring a source of seed electrons for generating plasma (plasma sources) utilized in plasma-based ionization, photoionization, illumination, surface cleaning, surface etching, surface treatment, surface functionalization, sterilization, etc.; vacuum tubes; incandescent light sources; heating devices; etc.

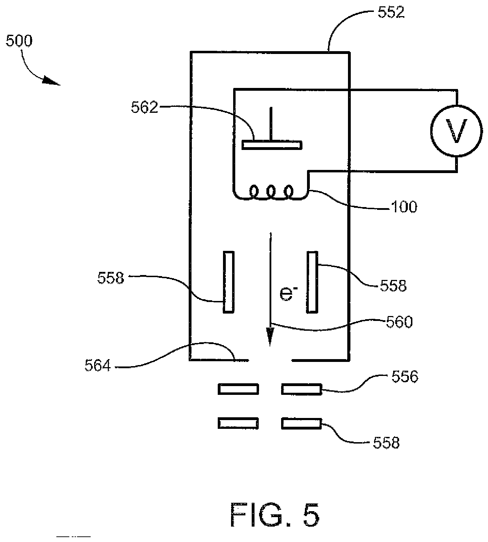

Figure 5 is a schematic view of an example of an electron source (or electron emitter) 500 according to an embodiment. The electron source 500 includes a filament assembly according to any of the embodiments disclosed herein, for example the filament assembly 100 (or 200, 300, or 400, or others). In some embodiments, the filament assembly 100 may include more than one filament, or more than one filament assembly 100 may be provided. The electron source 500 further includes a vacuum chamber 552. Depending on the embodiment, the vacuum chamber 552 may be evacuated and permanently sealed from the ambient, or may be capable of being evacuated and maintained at a desired vacuum level by a suitable vacuum pumping system (not shown). The electron source 500 may include an anode 556 and one or more additional electrodes (electron optics) 558 configured to focus and accelerate the as-generated electrons as an electron beam (or "e-beam") 560, and to steer the electron beam 560 as required in a given application, through the generation of one or more electrostatic fields of appropriate spatial and polar orientation. The electron optics 558 may include an electron repeller 562 positioned on a side of the filament assembly opposite to the intended direction of electron stream flow. The electron repeller 562 is biased appropriately to urge the as-generated electrons in the intended direction. Depending on the embodiment, the vacuum chamber 552 may include a small outlet 564 through which the electron beam 560 passes. The electron source 500 may be utilized in various applications as noted above, and may benefit from the provision of a filament assembly 100 (or 200, 300, or 400, or others) configured as taught herein.

Many techniques for analyzing a sample, and/or for detecting for the presence of a particular biological, chemical, or biochemical compound or trace element, require that the sample under investigation, which may be known or suspected of containing certain target analytes or a specific trace element, be ionized in preparation for analysis or detection by a mass spectrometer (MS). Devices configured to ionize samples are commonly known as ion sources. Ion sources may be classified according to whether they operate at vacuum or atmospheric pressure. Ion sources may be further classified according to the type of technique they implement to effect ionization. Some techniques are exclusively implemented in either the vacuum or atmospheric-pressure regime. In either case, the MS itself must operate at high vacuum (very low pressure).

One example of a vacuum ion source widely used in mass spectrometry (MS) is an electron (impact) ionization source, or EI source. In a typical EI source, sample material is introduced into an ionization chamber in the form of a molecular vapor. An electron emitter (or electron source) is employed to generate an electron beam in, or directed into, the ionization chamber for interaction with the sample material. A filament assembly, or a filament assembly and associated electron source, as disclosed herein may be utilized as the electron source in such applications. In operation, the sample to be analyzed or detected is introduced into the ionization chamber along a path that intersects the path of the electron beam. Ionization of the sample material occurs as a result of the electron beam bombarding the sample material in the region where the sample and electron paths intersect.

An MS-based analytical instrument in general includes an ion source such as an EI source as described herein, a mass analyzer for receiving the ions from the ion source and separating the ions based on their differing mass-to-charge ratios (or m/z ratios, or more simply "masses"), an ion detector for counting the separated ions, and electronics for processing output signals from the ion detector as needed to produce a user-interpretable mass spectrum. Typically, the mass spectrum is a series of peaks indicative of the relative abundances of detected ions as a function of their m/z ratios. The mass spectrum may be utilized to determine the presence of certain components of the sample, and further determine the molecular structures of components of the sample, thereby enabling the sample to be qualitatively and quantitatively characterized.

In still other applications, the MS-based analytical instrument utilizing an EI source is a leak detector that uses a tracer gas (e.g., helium, hydrogen, tritium, argon, etc.) to determine whether a manufactured article (a "device under test" or DUT, or "unit under test" or UUT) is leaking. In this case, tracer gas is the "sample." In one example, the interior of the DUT is fluidly connected to the EI source and placed in a test chamber. The test chamber is charged with pressurized helium, and the DUT is evacuated by the vacuum pumping system of the helium leak detector. If a leak is present, helium molecules in the test chamber pass through the leak site into the interior of the DUT, and into the EI source. In another example, the interior of the DUT itself is charged with pressurized helium and placed in a test chamber. The test chamber in this case is fluidly connected to the EI source and evacuated by the vacuum pumping system. If a leak is present, helium molecules in the interior of the DUT pass through the leak site into the test chamber, and into the EI source. In either case, the EI ionizes the helium molecules and transmits the resulting helium ions to the MS for detection and quantification.

In other embodiments, the EI source may be configured as a chemical ionization (CI) source. In this case, a reagent gas is admitted into the ionization chamber and is ionized by the electron beam. The resulting reagent ions interact with the sample material to produce the analyte ions, as appreciated by persons skilled in the art.

In other embodiments, a filament assembly and/or associated electron source as described herein may be configured in an MS to generate electrons utilized for fragmenting or dissociating ions by electron-capture dissociation (ECD), electron-transfer dissociation (ETD), or related techniques as appreciated by persons skilled in the art. In this case, the ion source positioned at the front end of the MS may be any type of ion source, and produces "parent" ions. The filament assembly and associated optics in this case may be positioned at a fragmentation chamber (or cell), which is located at a position on the ion optical axis (i.e., along the ion work flow) between the ion source and the MS. The electrons emitted from the filament assembly interact with the beam of parent ions in the fragmentation chamber to produce "daughter" ions, which may then be transmitted to the downstream MS.

In other embodiments the ion source, instead of being an EI or CI source, may be a plasma-based ion source in which plasma is produced and sustained by subjecting a plasma-forming gas to an appropriate input of energy (e.g., radio-frequency, microwave, etc.), as appreciated by persons skilled in the art. In this case, a filament assembly as described herein may be utilized for providing seed electrons that assist in striking the plasma from the initially non-energized plasma-forming gas. Sample ionization may be implemented by exposing the sample material to the plasma. Alternatively, the plasma may be confined behind a window that passes photons to the sample material, whereby sample ionization occurs by photoionization (PI).

For purposes of the present disclosure, it will be understood that when a layer (or film, region, substrate, component, device, or the like) is referred to as being "on" or "over" another layer, that layer may be directly or actually on (or over) the other layer or, alternatively, intervening layers (e.g., buffer layers, transition layers, interlayers, sacrificial layers, etch-stop layers, masks, electrodes, interconnects, contacts, or the like) may also be present. A layer that is "directly on" another layer means that no intervening layer is present, unless otherwise indicated. It will also be understood that when a layer is referred to as being "on" (or "over") another layer, that layer may cover the entire surface of the other layer or only a portion of the other layer. It will be further understood that terms such as "formed on" or "disposed on" are not intended to introduce any limitations relating to particular methods of material transport, deposition, fabrication, surface treatment, or physical, chemical, or ionic bonding or interaction. The term "interposed" is interpreted in a similar manner.

It will also be understood that, as used herein, the terms such as "in signal communication" or "in electrical communication" and derivatives thereof mean that two or more systems, devices, components, modules, or sub-modules are capable of communicating with each other via signals that travel over some type of signal path. The signals may be communication, power, data, or energy signals, which may communicate information, power, or energy from a first system, device, component, module, or sub-module to a second system, device, component, module, or sub-module along a signal path between the first and second system, device, component, module, or sub-module. The signal paths may include physical, electrical, magnetic, electromagnetic, electrochemical, optical, wired, or wireless connections. The signal paths may also include additional systems, devices, components, modules, or sub-modules between the first and second system, device, component, module, or sub-module.

More generally, terms such as "communicate" and "in ... communication with" (for example, a first component "communicates with" or "is in communication with" a second component) are used herein to indicate a structural, functional, mechanical, electrical, signal, optical, magnetic, electromagnetic, ionic or fluidic relationship between two or more components or elements. As such, the fact that one component is said to communicate with a second component is not intended to exclude the possibility that additional components may be present between, and/or operatively associated or engaged with, the first and second components.

It will be understood that various aspects or details of the invention may be changed without departing from the scope of the invention. Furthermore, the foregoing description is for the purpose of illustration only, and not for the purpose of limitation-the invention being defined by the claims.

## Claims

1. A filament assembly, comprising:
a core composed of an electrically insulating, high-melting point material and having a core length along a core axis; and
a filament composed of an electrically conductive, high-melting point material and comprising a first end, a second end, and an elongated body between the first end and the second end, wherein at least a central portion of the body is disposed on the core.

2. The filament assembly of claim 1, comprising at least one of the following features:
wherein the core has a configuration selected from the group consisting of: the core is solid; the core is hollow; the core is cylindrical; the core is composed of a refractory material; and a combination of two or more of the foregoing;
wherein the filament has a composition selected from the group consisting of: iridium; a refractory metal; a high-melting point metal; tungsten; rhenium; and an alloy of any of the foregoing.

3. The filament assembly of claim 1 or 2, wherein at least the central portion of the body extends along at least a portion of the core length in a high-resistance configuration, wherein in particular the high-resistance configuration is selected from the group consisting of:
the central portion is wound about the core in a helical path; and
the central portion extends along the core in a serpentine path.

4. The filament assembly of any of claims 1 to 3, comprising a thermionically emissive layer disposed on the core and encapsulating at least the central portion, the thermionically emissive layer having a work function lower than a work function of the filament, wherein in particular the thermionically emissive layer has a composition selected from the group consisting of: a thermionically emissive oxide or a mixture of two or more different thermionically emissive oxides; yttrium oxide or a mixture of yttrium oxide and one or more other thermionically emissive oxides; a thermionically emissive allotrope of carbon; carbon nanotubes; graphene; and a composite of two or more different carbon allotropes.

5. The filament assembly of any of claims 1 to 4, comprising a support structure on which the core is disposed, wherein in particular the support structure comprises an electrically conductive first post and an electrically conductive second post configured for electrical coupling to a voltage source, and the first end and the second end respectively electrically communicate with the first post and the second post.

6. A method for fabricating a filament assembly, the method comprising:
providing a core composed of an electrically insulating, high-melting point material and having a core length along a core axis;
providing a filament composed of an electrically conductive, high-melting point material and comprising a first end, a second end, and an elongated body between the first end and the second end; and
attaching the filament to the core such that at least a central portion of the body is disposed on the core.

7. The method of claim 6, wherein the core has a configuration selected from the group consisting of: the core is solid; the core is hollow; the core is cylindrical; the core is composed of a refractory material; and a combination of two or more of the foregoing.

8. The method of claim 6 or 7, wherein at least the central portion of the body extends along at least a portion of the core length in a high-resistance configuration.

9. The method of claim 8, wherein the high-resistance configuration is selected from the group consisting of:
the central portion is wound about the core in a helical path; and
the central portion extends along the core in a serpentine path.

10. The method of any of claims 6 to 9, comprising applying a thermionically emissive layer to the core such that the thermionically emissive layer encapsulates at least the central portion, the thermionically emissive layer having a work function lower than a work function of the filament.

11. The method of claim 10, wherein the thermionically emissive layer has a composition selected from the group consisting of: a thermionically emissive oxide or a mixture of two or more different thermionically emissive oxides; yttrium oxide or a mixture of yttrium oxide and one or more other thermionically emissive oxides; a thermionically emissive allotrope of carbon; carbon nanotubes; graphene; and a composite of two or more different carbon allotropes.

12. The method of any of claims 6 to 11, comprising mounting the core on a support structure, wherein in particular the support structure comprises an electrically conductive first post and an electrically conductive second post configured for electrical coupling to a voltage source, and further comprising placing the first end and the second end in electrical communication with the first post and the second post, respectively.

13. The method of any of claims 6 to 12, comprising forming at least the central portion into the high-resistance configuration by a process selected from the group consisting of:
forming or placing a layer of filament material on the core, coating the layer of filament material with a photoresist, patterning the photoresist according to the high-resistance configuration, and applying an etchant;
forming or placing a layer of filament material on the core, applying a mask to the filament material, the mask being patterned according to the high-resistance configuration, and applying an etchant; and
applying a mask to the core, the mask being patterned according to the high-resistance configuration, and depositing filament material through the mask.

14. The method of any of claims 6 to 13, wherein providing the core is selected from the group consisting of:
filling a hollow tube of filament material with a slurry comprising core material, forming the core by solidifying the core material, and forming the filament with the high-resistance configuration from the hollow tube; and
inserting the core into a hollow tube of filament material, and forming the filament with the high-resistance configuration from the hollow tube.

15. The method of any of claims 6 to 14, wherein at least the central portion of the body is a wire, and providing the filament comprises mounting the wire to the core.
